(19) Europäisches Patentamt
European Patent Office
Office européen des brevets

(11) **EP 4 391 740 A1**

(12) **EUROPEAN PATENT APPLICATION**
published in accordance with Art. 153(4) EPC

(43) Date of publication:
**26.06.2024 Bulletin 2024/26**

(21) Application number: **22857647.6**

(22) Date of filing: **09.08.2022**

(51) International Patent Classification (IPC):
**H05K 3/36** (2006.01)    **H05K 1/14** (2006.01)
**H01R 12/71** (2011.01)

(52) Cooperative Patent Classification (CPC):
**H01R 12/71; H05K 1/14; H05K 3/36**

(86) International application number:
**PCT/CN2022/111141**

(87) International publication number:
**WO 2023/020335 (23.02.2023 Gazette 2023/08)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **19.08.2021   CN 202110955571
19.08.2021   CN 202121957178 U**

(71) Applicants:
• **Phoenix Contact Asia-Pacific (Nanjing) Co., Ltd.
Nanjing, Jiangsu 211100 (CN)**
• **PHOENIX CONTACT GmbH & Co. KG
32825 Blomberg (DE)**

(72) Inventors:
• **LUO, Min
Nanjing, Jiangsu 211100 (CN)**
• **YE, Qing
Nanjing, Jiangsu 211100 (CN)**
• **YU, Xiaopeng
Nanjing, Jiangsu 211100 (CN)**
• **MULLER, Alexander
32825 Blomberg (DE)**
• **HOGE, Frank
32825 Blomberg (DE)**

(74) Representative: **Pfenning, Meinig & Partner mbB
Patent- und Rechtsanwälte
Theresienhöhe 11a
80339 München (DE)**

(54) **PRINTED CIRCUIT BOARD ASSEMBLY AND DESIGN AND MANUFACTURING METHOD THEREFOR**

(57)    The present invention relates to a manufacturing method of a printed circuit board assembly, comprising: manufacturing a first printed circuit board comprising one or more positioning jacks; manufacturing a second printed circuit board comprising one or more positioning pins extending from a first edge of the second printed circuit board, the positioning pin having a substantially rectangular cross-sectional shape in a plane perpendicular to an extension direction of the positioning pin; wherein the one or more positioning pins of the second printed circuit board are configured to be respectively plugged into the one or more positioning jacks of the first printed circuit board, and a diagonal length c of the cross-section of the positioning pin is larger than a diameter $d$ of the positioning jack, producing an interference fit between the positioning jack and the positioning pin.

Fig. 3

**Description**

TECHNICAL FIELD

The present invention relates to the field of circuit, and more specifically, to printed circuit board assembly, as well as designing and manufacturing method thereof.

BACKGROUND

In electronic device, printed circuit boards (PCBs) are widely used. In some practical applications, two PCBs need to be connected together and perpendicularly to each other to form a PCB assembly. A conventional connection approach is to form pins (e.g. pins with copper plating) on the edge of one of the PCBs (a first PCB) and have jacks designed on the other PCB (a second PCB) to accommodate the pins. The pins and jacks are soldered during wave soldering process, thereby connecting the two PCBs mechanically and electrically.

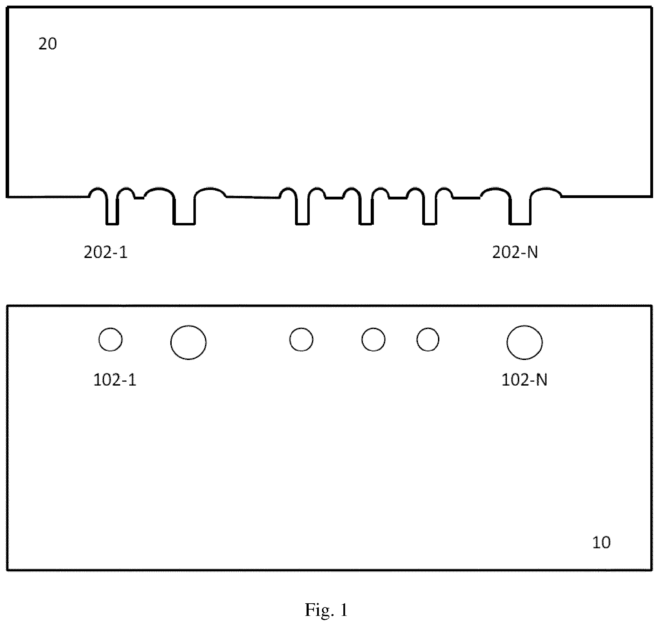

Fig. 1 depicts a PCB assembly belonging to the prior art described above, which includes two printed circuit boards to be connected perpendicularly to each other. As shown in Fig. 1, a printed circuit board 10 (hereinafter referred to as a first printed circuit board 10, or PCB 10) may include one or more jacks 102-1 to 102-N, and a printed circuit board 20 (hereinafter referred to as a second printed circuit board 20, or PCB 20) includes one or more pins 202-1 to 202-N extending out from one of its edges. Generally speaking, pins 202-1 to 202-N and jacks 102-1 to 102-N are electrically conductive, such as coated with a metal layer. Pins 202-1 to 202-N can be inserted into jacks 102-1 to 102-N respectively, and the pins and jacks are soldered together by soldering technology (e.g., wave soldering), thereby enabling mechanical and electrical connections of the two PCBs. In the process of forming the PCB assembly with the above structure, in order to meet the stability requirement during the wave soldering process, after the pins 202-1 to 202-N of the PCB 20 are respectively inserted into the jacks 102-1 to 102-N on the PCB 10, the two PCBs need to be firmly positioned together through a fixture or other form of mechanical support. After being positioned with the fixture, the pins 202-1 to 202-N of the PCB 20 and the jacks 102-1 to 102-N on the PCB 10 are soldered together by wave soldering process, to achieve mechanical and electrical connection of the two PCBs. After the wave soldering step is completed, the fixture is removed. The use of this kind of fixture is very unfavorable to the automation of production, affecting production efficiency. At the same time, PCB assemblies of different specifications may require the use of different fixtures, which also increases production cost. Therefore, there is a need for a PCB assembly that can be manufactured using soldering manufacturing process (such as wave soldering) without the use of fixture. Furthermore, when designing such PCB assembly that can be soldered and manufactured without using fixture, it is desired to accurately and effectively determine the design dimensions of the pinboard structure, so that the stability of the mechanically-plugged PCB assembly meets welding process requirement, while it can be ensured that PCB assembly do not have defect.

SUMMARY

The present invention provides a manufacturing method of a printed circuit board assembly, comprising: manufacturing a first printed circuit board comprising one or more positioning jacks; manufacturing a second printed circuit board comprising one or more positioning pins extending from a first edge of the second printed circuit board, the positioning pin having a substantially rectangular cross-sectional shape in a plane perpendicular to an extension direction of the positioning pin; wherein the one or more positioning pins of the second printed circuit board are configured to be respectively plugged into the one or more positioning jacks of the first printed circuit board, and a diagonal length c of the cross-section of the positioning pin is larger than a diameter d of the positioning jack, producing an interference fit between the positioning jack and the positioning pin, wherein adopting the following definitions: a design size the cross-sectional width of the positioning pin is w and a processing tolerance thereof is $\pm a$, a design thickness of the second printed circuit board is t and a processing tolerance thereof is $\pm x\%$, and Amin and Amax are the minimum target value and the maximum target value of an interference amount, and an actual size range of the diameter d of the positioning jack are to be determined according to the following formulas:

$$\sqrt{(w - a)^2 + [(1 - x\%) * t]^2} - d \geq \mathrm{Amin}$$

$$\sqrt{(w + a)^2 + [(1 + x\%) * t]^2} - d \leq Amax$$

further determining, based on the actual size range of the diameter d of the positioning jack and a processing tolerance

$\pm b$ of the positioning jack, a design size range of the diameter $d$, and wherein the positioning jack and wherein the positioning pin are to be manufactured according to design sizes of parameters $w$, $t$ and d.

The present invention provides another manufacturing method of a printed circuit board assembly, comprising: manufacturing a first printed circuit board comprising one or more positioning jacks; manufacturing a second printed circuit board comprising one or more positioning pins extending from a first edge of the second printed circuit board, the positioning pin having a substantially rectangular cross-sectional shape in a plane perpendicular to an extension direction of the positioning pin; wherein the one or more positioning pins of the second printed circuit board are configured to be respectively plugged into the one or more positioning jacks of the first printed circuit board, and a diagonal length c of the cross-section of the positioning pin is larger than a diameter d of the positioning jack, producing an interference fit between the positioning jack and the positioning pin, wherein, adopting the following definitions: a design size of the diameter of the positioning jack is $d$ and a processing tolerance thereof is $\pm b$, a design thickness of the second printed circuit board is t and a processing tolerance thereof is $\pm x\%$, and Amin and Amax are the minimum target value and the maximum target value of an interference amount, and an actual size range of the cross-sectional width w of the positioning pin are to be determined according to the following formulas:

$$\sqrt{(w^2 + [(1 - x\%) * t]^2} - (d + b) \geq Amin;$$

$$\sqrt{(w^2 + [(1 + x\%) * t]^2} - (d - b) \leq Amax$$

further determining, based on the actual size range of the cross-sectional width w of the positioning pin and a processing tolerance $\pm a$ of the positioning pin, a design size range of the cross-sectional width w, and wherein the positioning jack and the positioning pin are to be manufactured according to design sizes of parameters $w$, $t$ and d.

The present invention also provides a manufacturing method of a printed circuit board assembly, comprising: manufacturing a first printed circuit board comprising one or more positioning jacks; manufacturing a second printed circuit board comprising one or more positioning pins extending from a first edge of the second printed circuit board, the positioning pin having a substantially rectangular cross-sectional shape in a plane perpendicular to an extension direction of the positioning pin; wherein the one or more positioning pins of the second printed circuit board are configured to be respectively plugged into the one or more positioning jacks of the first printed circuit board, and a diagonal length c of the cross-section of the positioning pin is larger than a diameter d of the positioning jack, producing an interference fit between the positioning jack and the positioning pin, defining a design size the cross-sectional width of the positioning pin to be w and a processing tolerance thereof to be $\pm a$, defining a design size of the diameter of the positioning jack is $d$ and a processing tolerance thereof to be $\pm b$, defining a design thickness of the second printed circuit board to be t and a processing tolerance thereof to be $\pm x\%$, defining Amin and Amax to be the minimum target value and the maximum target value of an interference amount, and taking the following formulas as design constrains for parameters $w$, $d$ and $t$:

$$\sqrt{(w + a)^2 + [(1 + x\%) * t]^2} - \text{Amax} \leq (d - b) \leq (d + b)$$
$$\leq \sqrt{(w - a)^2 + [(1 - x\%) * t]^2} - Amin$$

wherein the positioning jack and the positioning pin are to be manufactured according to design sizes of the parameters $w$, $d$ and $t$ that satisfy the above constrains.

The manufacturing methods as above, wherein the minimum target value Amin and the maximum target value Amax are reference base values determined through a verification process.

The manufacturing methods as above, wherein the minimum target value Amin and the maximum target value Amax satisfy the following verification conditions: when the interference amount is not lower than the minimum target value Amin, the stability of the first printed circuit board and the second printed circuit board that are mechanically connected meets requirement of welding process; when the interference amount does not exceed the maximum target value Amax, there is no defect of circuit board on the first printed circuit board caused by excessive interference.

The manufacturing methods as above, wherein a range of the minimum target value Amin is 0.06~0.30 millimeters, and a range of the maximum target value Amax is 0.60~0.90 millimeters.

The manufacturing methods as above, wherein the positioning jack of the first printed circuit board and the positioning pin of the second printed circuit board do not include metal plating, and a material of the positioning pin is the same as a substrate material of the second printed circuit board.

The manufacturing methods as above, wherein the positioning pin includes an extension section with a constant width and an end portion with a narrowing width, and the length *l* of the extension section is greater than a thickness of the first printed circuit board.

The manufacturing methods as above, wherein an end of the positioning pin includes a chamfer.

The manufacturing methods as above, wherein the one or more positioning pins comprise 1 to 3 positioning pins, and the one or more positioning jacks comprise 1 to 3 positioning jacks.

The manufacturing methods as above, wherein the first printed circuit board further comprises one or more conductive jacks, and the second printed circuit board further comprises one or more conductive pins extending from the first edge of the second printed circuit board, and the one or more conductive pins and the one or more conductive jacks are applicable to establishing electrical connections by soldering.

The manufacturing methods as above, wherein a value of the processing tolerance $\pm x\%$ is 0.

The manufacturing methods as above, wherein a value of the processing tolerance $\pm a$ is 0.

The manufacturing methods as above, wherein a value of the processing tolerance $\pm b$ is 0.

The present invention also relates to a printed circuit board assembly, comprising: a first printed circuit board comprising one or more positioning jacks; a second printed circuit board comprising one or more positioning pins extending from a first edge of the second printed circuit board, the positioning pin having a substantially rectangular cross-sectional shape in a plane perpendicular to an extension direction of the positioning pin; wherein the one or more positioning pins of the second printed circuit board are configured to be respectively plugged into the one or more positioning jacks of the first printed circuit board, a diagonal length c of the cross section of the positioning pin is greater than a diameter d of the positioning jack, producing an interference fit between the positioning jack and the positioning pin.

The printed circuit board assembly as above, wherein the positioning jack of the first printed circuit board and the positioning pin of the second printed circuit board do not include metal plating, and a material of the positioning pin is the same as a substrate material of the second printed circuit board.

The printed circuit board assembly as above, wherein the positioning pin includes an extension section with a constant width and an end portion with a narrowing width, and the length *l* of the extension section is greater than a thickness of the first printed circuit board.

The printed circuit board assembly as above, wherein an end of the positioning pin includes a chamfer.

The printed circuit board assembly as above, wherein the one or more positioning pins comprise 1 to 3 positioning pins, and the one or more positioning jacks comprise 1 to 3 positioning jacks.

The printed circuit board assembly as above, wherein the number of the positioning pin is equal to the number of the positioning jack.

The printed circuit board assembly as above, wherein the first printed circuit board comprises two positioning jacks, and the second printed circuit board comprises two positioning pins.

The printed circuit board assembly as above, wherein the numbers of the positioning pin and the positioning jack are determined according to a size of the second printed circuit board: when a length M and a width N of the second printed circuit board satisfy the following sizes, the first printed circuit board comprises one positioning jack and the second printed circuit board comprises one positioning pin:

$$M < 50mm, N < 50mm;$$

when the length M and the width N of the second printed circuit board satisfy the following sizes, the first printed circuit board comprises 2 positioning jacks and the second printed circuit board comprises 2 positioning pins:

$$M < 50mm, 50mm \leq N < 150mm ;$$

$$50mm \leq M < 150mm, N < 50mm;$$

or

$$50mm \leq M < 150mm, 50mm \leq N < 150mm;$$

when the length M and the width N of the second printed circuit board satisfy the following sizes, the first printed circuit board comprises 3 positioning jacks and the second printed circuit board comprises 3 positioning pins:

$$150\text{mm} \leq M < 200\text{mm}, \; N < 50\text{mm};$$

or

$$150\text{mm} \leq M < 200\text{mm}, \; 50\text{mm} \leq N < 150\text{mm}.$$

The printed circuit board assembly as above, wherein the first printed circuit board further comprises one or more conductive jacks, and the second printed circuit board further comprises one or more conductive pins extending from the first edge of the second printed circuit board, and the one or more conductive pins and the one or more conductive jacks establish electrical connections by soldering.

The printed circuit board assembly as above, wherein the cross-sectional width w of the positioning pin is smaller than the diameter d of the positioning jack.

The printed circuit board assembly as above, wherein the first printed circuit board and the second printed circuit board are vertically connected.

The printed circuit board assembly as above, wherein when the number of the positioning jack and the number of the positioning pin are greater than or equal to 2 respectively, sizes of at least two positioning jacks are different from each other, and accordingly, sizes of at least two positioning pins are different from each other.

The printed circuit board assembly as above, wherein when the cross-sectional width of the positioning pin is defined as $w$, and the design thickness of the second printed circuit board is defined as $t$, then the $t$, $d$ and $w$ of the printed circuit board assembly satisfy the following constraints:

$$\sqrt{w^2 + t^2} - \text{Amax} \leq d \leq \sqrt{w^2 + t^2} - \text{Amin}$$

wherein Amax is a maximum of an interference amount $c\text{-}d$ obtained by subtracting the diameter $d$ of the positioning jack from the diagonal length $c$ of the cross-section of the positioning pin, and Amin is a minimum of the interference amount $c\text{-}d$.

The PCB assembly manufactured according to the present invention can make two PCBs secured to each other without using a fixture, thereby facilitating the use of soldering manufacturing processes such as wave soldering. Furthermore, the present invention solves the problem of accuracy for the size design of positioning pin and positioning jack. The PCB assembly manufactured according to this design requirement, after being plugged, can meet the stability requirement of the PCB assembly during the welding process, and can ensure that PCB assembly do not have defect.

BRIEF DESCRIPTION OF THE DRAWINGS

To further set forth embodiments of the invention, a more specific description of embodiments of the invention will be presented with reference to the accompanying drawings. It is to be understood that the drawings depict only typical embodiments of the invention and are therefore not to be considered limiting of the scope of the invention as claimed.

In addition, it should be understood that the main relationships of connection of various components, rather than all relationships of connection, are shown in the drawings. The components and connections in the drawings are not necessarily drawn to actual scale.

Fig. 1 is a schematic diagram of a connection structure of two printed circuit boards (PCBs) according to the prior art;

Fig. 2 is a schematic diagram of a connection structure of two PCBs according to an embodiment of the present invention;

Fig. 3 is a side cross-sectional view of two PCBs connected together in a plug-in manner in a PCB assembly according to an embodiment of the present invention;

Fig. 4 is a top view of two PCBs connected together in a plug-in manner in a PCB assembly according to an embodiment of the present invention;

Fig. 5 is a schematic diagram of an interference fit between a positioning jack on a first PCB and a positioning pin on a second PCB according to an embodiment of the present invention.

DETAILED DESCRIPTION

The following detailed description refers to the accompanying drawings. The drawings illustrate by way of illustration specific embodiments in which the claimed subject matter may be practiced. It should be understood that the following specific embodiments are intended to specifically describe typical examples for the purpose of illustration, but should not be understood as limiting of the present invention. Those skilled in the art, when fully understanding the spirit and scope of the present invention, could make suitable modifications and adjustments to the disclosed embodiments without departing from the spirit and scope of the claimed subject matter.

In the following detailed description, numerous specific details are set forth in order to provide a thorough understanding of the various described embodiments. However, it would be apparent to one of ordinary skill in the art that the various embodiments described may be practiced without these specific details. Unless otherwise defined, technical and scientific terms used herein shall have the same meaning as commonly understood by one of ordinary skill in the art to which this disclosure belongs.

The terms "first", "second", etc. in the Specification and Claims of the present application do not imply any order, quantity or importance, but are only used to distinguish different components or features. Embodiments are exemplary implementations or examples. Reference in the Specification to "embodiments," "one embodiment," "some embodiments," "various embodiments," or "other embodiments" means that a particular feature, construction, or characteristic described in connection with the embodiment is included in at least some, but not necessarily all, embodiments of the technology. The various appearances of "embodiments," "one embodiment," or "some embodiments" do not necessarily all refer to the same embodiment. Elements or aspects from one embodiment may be combined with elements or aspects from another embodiment.

The present invention will be further described below in conjunction with the accompanying drawings.

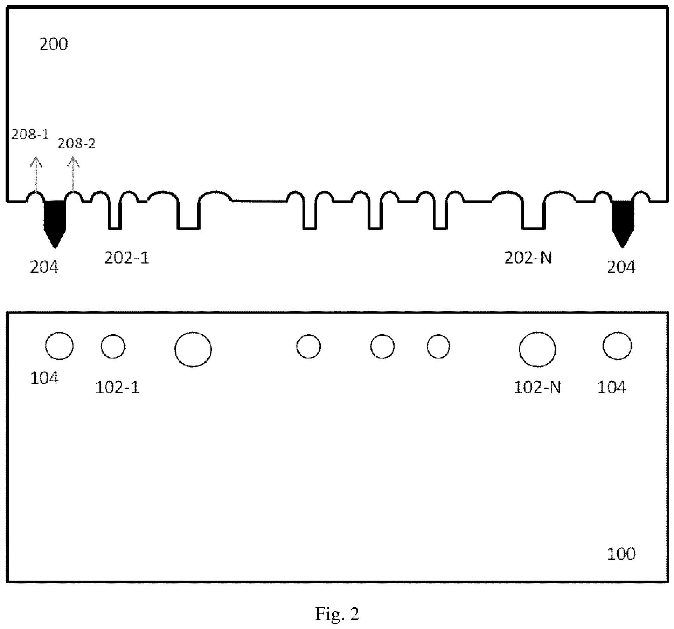

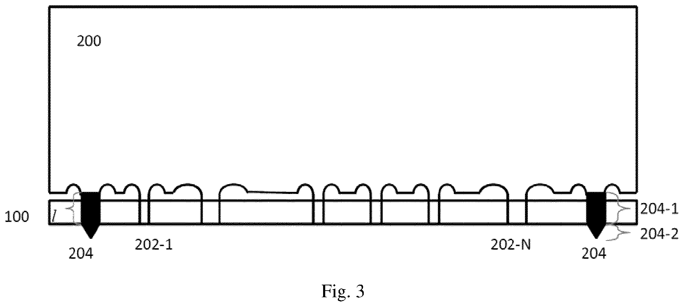

Fig. 2 is a PCB assembly according to an embodiment of the present invention. The two PCBs included in the PCB assembly have a novel structure for plugging, so as to establish a sufficiently stable relationship of mechanical connection after mutual plugging of the two PCBs, thereby being suitable for use with soldering manufacturing processes such as wave soldering without the use of fixture. In an embodiment of the present invention, one or more positioning jacks 104 etc. may be provided on the first PCB 100. On one edge of the second PCB 200, one or more positioning pins 204 etc. extending therefrom are formed. In a preferred embodiment, the number of positioning jacks 104 is equal to the number of positioning pins 204. The positioning jack 104 may have a substantially circular cross-sectional shape. The positioning pin 204 may be a structure extending from the PCB 200, and thus, the thickness t of the positioning pin may be identical to the thickness of the PCB 200. With reference to Fig. 3, the positioning pin 204 has an extension section 204-1 with a constant width and an end portion 204-2 with a narrowing width. In a preferred embodiment, the first PCB 100 and the second PCB 200 are vertically inserted.

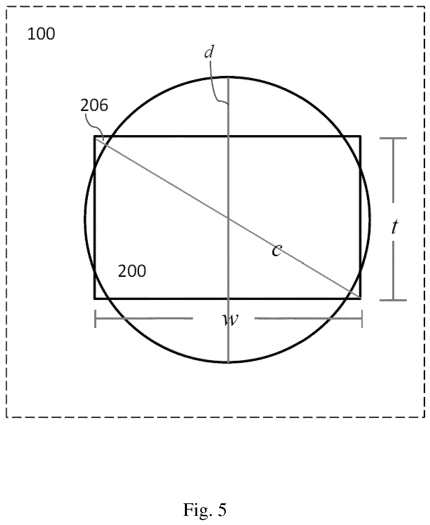

Fig. 5 shows the structure of the positioning jack and positioning pin viewed from the back side of the PCB 100 (the side opposite to the side to be interfacing and connected with the PCB 200). It can be understood that the positioning pin 204 viewed from the perspective of Fig. 5 has a rectangular cross-section, where one side of the rectangle is the thickness t of the positioning pin (that is, the thickness of the PCB 200), and another side of the rectangle is the width w of the positioning pin. The positioning jack 104 viewed in the perspective of Fig. 5 has a circular cross-section, which may have a diameter d. In the present invention, the diagonal length c of the rectangular cross-section is designed to be larger than the diameter d of the positioning jack 104. By making the diagonal length c greater than the diameter d, an interference fit is formed between the positioning pin 204 and the positioning jack 104 after the second PCB 200 the first PCB 100 are connected by plugging, thereby stably sticking the second PCB 200 to the first PCB 100 without the need for an additional fixture to secure the second PCB 200 to the first PCB 100.

Optionally, further controlling condition include: the width w of the cross section of the positioning pin 204 is smaller than the diameter d of the positioning jack 104, which controls the area of the corner 206 used to generate the interference to be within a certain range.

According to a preferred embodiment of the present invention, the positioning jack 104 of the first PCB 100 and the positioning pin 204 of the second PCB 200 are only used to form a firm mechanical connection, and thus, they do not comprise metal plating. The material of the positioning pin 204 may be the same as the substrate material of the second PCB 200. Therefore, during the designing and manufacturing process of the substrate of the second PCB 200, appropriate shape and dimensions may be designed for the positioning pin, and then one or more positioning pins 204 are formed integrally with the second PCB 200.

Also shown in Fig. 2 are arc-shaped cuts 208-1 and 208-2 formed on the left and right sides of the positioning pin 204. This arc-shaped cut can help adjust pressure distribution.

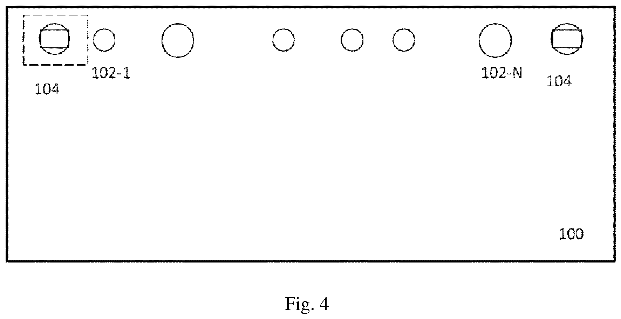

Referring now to Figs. 3-4. Fig. 3 is a side cross-sectional view of two PCBs connected together in a plug-in manner in a PCB assembly according to an embodiment of the present invention. Fig. 4 is a top view of two PCBs connected together in a plug-in manner in a PCB assembly according to an embodiment of the present invention. As shown in the side cross-sectional view of Fig. 3, the length l of the extension section 204-1 of the positioning pin 204 may be formed to be slightly larger than the thickness of the first PCB 100. This length design can further prevent the positioning pin 204 from vibrating in the jack 104 of the first PCB 100, causing the connection of the two PCBs more secured. In a preferred embodiment of the present invention, as shown in Figs. 2 and 3, a chamfer may be formed at the end 204-2 of the positioning pin 204. The chamfer structure may be used to assist in plugging the positioning pin 204 into the positioning jack 104. After the two PCBs are connected and soldered, the chamfer structure can be appropriately processed to meet specific application need. The present invention does not intend to limit this aspect.

Referring to Fig. 5 again, it illustrates the principle of interference fit between the positioning jack 104 on the first PCB 100 and the positioning pin 204 on the second PCB 200 according to an embodiment of the present invention. Fig. 5 is an enlarged view of the structure within the dotted-line block on the left side of Fig. 4. As mentioned before, the diagonal length c of the rectangular cross-section of the positioning pin 204 can be designed to be larger than the diameter d of the positioning jack 104; the positioning pin 204 can have a thickness *t* which can be the thickness of the second PCB 200, and the thickness *t* of the positioning pin 204 is the length of one side of the rectangular cross-section of the positioning pin. The rectangular cross-section of the positioning pin 204 may also have a width w. Based on the thickness t and width w of the rectangular cross-section of the positioning pin 204, the diagonal length c of the rectangular cross-section can be calculated according to the Pythagorean theorem.

By making the diagonal length c of the rectangular cross-section of the positioning pin larger than the diameter d of the positioning jack, the four corners 206 of the rectangular cross-section will be outside the circumference of the positioning jack. The corner 206 can be appropriately squeezed and deformed in the process of the positioning pin 204 being plugged into the positioning jack 104, so that the positioning pin 204 is firmly stuck in the positioning jack 104, thereby firmly fixing the two PCBs.

In one embodiment, when the number of positioning jack 104 and the number of positioning pin 204 are greater than or equal to 2 respectively, for the purpose of fool-proof plugging, the sizes of positioning jacks 104 can be different from each other, and accordingly, the sizes of positioning jacks 104 corresponding respectively to the positioning jacks 104 can be different from each other.

According to one embodiment, after the two PCBs are secured through the interference fit of the positioning pin 204 and the positioning jack 104, the conductive pins 202-1 to 202-N on the second PCB 200 and the conductive jacks 102-1 to 102-N on the first PCB 100 also form a corresponding plug-in relationship, and thus are suitable for being soldered together, thereby achieving electrical connection of the two PCBs. However, it shall be understood that electrical connections based on conductive pins 202-1 to 202-N and conductive jacks 102-1 to 102-N are not necessary. According to the actual conditions of the PCB assembly, other methods can be used to realize the electrical connection of the two PCBs.

According to a preferred embodiment of the present invention, the value by which the diagonal length c of the cross-section of the positioning pin 204 of the second PCB 200 is greater than the diameter d of the positioning jack of the first PCB 100 is defined as an interference amount *c-d.* In the design of the present invention, the inventor considers the following two technical requirements: (1) the stability of the mechanically connected first printed circuit board and the second printed circuit board meets the requirement of soldering process; (2) there is no defect of circuit board on the first printed circuit board caused by excessive interference (for example, a large-area "halo" on the first PCB 100 due to excessive interference fit). Through a large number of experimental verifications, the above technical requirements can be met by setting the interference amount to be within a certain range. Specifically, the inventor used PCBs of various conventional sizes (for example, PCBs of Fr-4 material with thicknesses of 1.6 mm, 2 mm, etc.), conducted plugging experiments on positioning pins and positioning jacks of different sizes, and determined a plug-in match of the maximum positioning jack and the minimum positioning pin, as well as a plug-in match of the minimum positioning jack and the maximum positioning pin, which can meet the above technical requirements, and then determined an optimal range of interference amount that can meet the above two aspects of technical requirements. In addition, the fixedly-connected PCB assembly further complies with the anti-vibration standards of industrial equipment.

Therefore, the present invention includes a PCB assembly comprising a first PCB 100 and a second PCB 200, wherein the size of the positioning pin 204 of the second PCB 200 and the size of the positioning jack 104 of the first PCB 100 are designed to fall within the optimal range of interference amount to achieve a good fixation effect between the two PCBs.

The optimal range of interference amount is between the minimum target value Amin and the maximum target value Amax. The minimum target value Amin ranges from 0.06 to 0.30 mm, and the maximum target value Amax ranges from 0.60 to 0.90 mm, or they can be other parameter range verified. For example, the range of the interference amount defined by the minimum target value Amin and the maximum target value Amax satisfies the following verification conditions: when the interference amount is not lower than the minimum target value Amin, the stability of the first printed circuit board and the second printed circuit board that are mechanically connected meets the requirement of welding process; when the interference amount does not exceed the maximum target value Amax, there is no defect of circuit board caused by excessive interference on the first printed circuit board.

It should be noted that the values of the minimum target value Amin and the maximum target value Amax in the embodiment of the present invention are not limited to this. In practical applications, other range of values can be determined according to the specific shape, quantity, material and other verification conditions of pinboard structure of the PCB assembly.

In a further embodiment, a PCB assembly design method according to the present invention is proposed. The design method is used to determine the design dimensions of the positioning pin and/or positioning jack, to ensure that the interference amounts of the positioning pin and positioning jack of the manufactured PCB can fall within the optional range of the interference amount while considering the tolerance. In the following embodiments, the minimum target value Amin is set to be 0.21 mm, and the maximum target value Amax is set to be 0.77 mm.

Design Embodiment 1

Design embodiment 1 is used to determine the design diameter of the positioning jack.
In the actual manufacturing process, there usually exist processing tolerance. Assuming that the design thickness of the second PCB is t, its processing tolerance is $\pm x\%$, and the cross-sectional design width of the positioning pin 204 is w, its processing tolerance is $\pm a$ mm, then the present invention, with knowledge of design parameters t and w as well as the processing tolerances x and a, can determine actual value of a diameter $d$ of the positioning jack 104 according to the following formula:

$$\sqrt{(w-a)^2 + [(1-x\%) * t]^2} - d \geq 0.21 \qquad （1）$$

$$\sqrt{(w+a)^2 + [(1+x\%) * t]^2} - d \leq 0.77 \qquad （2）$$

wherein, formula (1) corresponds to the situation where the interference amount is the minimal one (Amin is 0.21 mm) obtained by the maximum positioning jack and the minimum positioning pin after considering the processing tolerance. Formula (2) corresponds to the situation where the interference amount is the maximal one (Amax is 0.77 mm) obtained by the minimum positioning jack and the maximum positioning pin after considering the processing tolerance.
For example, in a non-limiting example of determining the design size, assuming that a design thickness $t$ of the second PCB is 1.6 mm (such that the thickness of the positioning pin is also 1.6 mm), the processing tolerance of the thickness of the second PCB is about $\pm 10\%$ (that is, the manufactured thickness $t$ is 0.9 to 1.1 times the design thickness $t$), the design width w of the cross-section of the positioning pin 204 is determined to be 2.10 mm, and its processing tolerance is about $\pm 0.1$ mm, these relevant data can be put into formulas (1) and (2), and then the required actual diameter $d$ of the positioning jack 104 can be determined according to the following formula:

$$\sqrt{(2.10-0.1)^2 + [0.9 * 1.6]^2} - d \geq 0.21 \qquad （3）$$

$$\sqrt{(2.10+0.1)^2 + [1.1 * 1.6]^2} - d \leq 0.77 \qquad （4）$$

wherein, formula (3) corresponds to the situation where the interference amount is the minimal one obtained by the maximum positioning jack and the minimum positioning pin after considering the processing tolerance. Formula (4) corresponds to the situation where the interference amount is the maximal one obtained by the minimum positioning jack and the maximum positioning pin after considering the processing tolerance. The actual size range that $d$ should satisfy, which is solved based on formulas (3) and (4), is [2.05, 2.25] (accuracy is set to be 0.01).
On this basis, further considering the processing tolerance of the positioning jack, the design size of the diameter $d$ of the positioning jack can be determined. If the processing tolerance of the positioning jack 104 is also about $\pm 0.1$ mm, then in the design stage, the design size of the diameter $d$ of the positioning jack 104 can be determined to be 2.15 mm. In this way, the actually manufactured positioning jack, when taking the processing tolerance into consideration, can still meet the above requirements of the interference fit range [2.05, 2.25].

Design Embodiment 2

Design embodiment 2 is used to determine the design width of the cross-section of the positioning pin.
Assuming that the design thickness of the second PCB is $t$, its processing tolerance is $\pm x\%$, and the design diameter of the positioning jack 104 is $d$, its processing tolerance is $\pm b$ mm, then the present invention, with knowledge of design parameters $t$ and $d$ and the processing tolerance $x$ and $b$, can determine actual value of the cross-sectional width w of the positioning pin according to the following formula:

$$\sqrt{(w^2 + [(1 - x\%) * t]^2} - (d + b) \geq 0.21 \qquad （5）$$

$$\sqrt{(w^2 + [(1 + x\%) * t]^2} - (d - b) \leq 0.77 \qquad （6）$$

wherein, formula (5) corresponds to the maximum positioning jack and the minimum positioning pin, namely, the situation where the interference amount is the minimal one (Amax is 0.21 mm). Formula (6) corresponds to the minimum positioning jack and the maximum positioning pin, namely, the situation where the interference amount is the maximal one (Amax is 0.77 mm).

For example, in a non-limiting embodiment of the present invention, assuming that a design thickness $t$ of the PCB is 1.6 mm (such that the thickness of the positioning pin is also 1.6 mm), the processing tolerance of the thickness of the PCB is about $\pm 10\%$ (that is, the manufactured thickness $t$ is 0.9 to 1.1 times the design thickness $t$), the design diameter $d$ of the positioning jack 104 is 2.15 mm, and its processing tolerance is about $\pm 0.1$ mm, the supposed actual value of the cross-section width $w$ of the positioning pin 204 can be determined according to the following formula:

$$\sqrt{(w^2 + [0.9 * 1.6]^2} - (2.15 + 0.1) \geq 0.21 \qquad （7）$$

$$\sqrt{(w^2 + [1.1 * 1.6]^2} - (2.15 - 0.1) \leq 0.77 \qquad （8）$$

wherein, formula (7) corresponds to the maximum positioning jack and the minimum positioning pin, namely, the situation where the interference amount is the minimal one. Formula (8) corresponds to the minimum positioning jack and the maximum positioning pin, namely, the situation where the interference amount is the maximal one. The actual size range that w should satisfy, which is solved based on formulas (7) and (8), is [2.00, 2.20] (accuracy is set to be 0.01).

On this basis, further considering the processing tolerance of the positioning pin, the design size of the width w of the positioning pin can be determined. If the processing tolerance of cross-section width w of the positioning pin 204 is also about $\pm 0.1$ mm, then in the design stage, the design size of the cross-section width $w$ of the positioning pin 204 can be determined to be 2.10 mm. In this way, the actually manufactured positioning pin, when taking the processing tolerance into consideration, can still meet the above requirements of the interference fit range [2.00, 2.20].

Combining Design Embodiment 1 and Design Embodiment 2, it can be seen that when the second PCB thickness is selected (the thickness $t$ of the positioning pin can be known at this time), as long as the design dimension of one of the diameter $d$ of the positioning jack or the cross-sectional width $w$ of the positioning pin is designed, the design dimension of the other can be determined according to the above formulas (1)-(2), (5)-(6).

In the above design example, the minimum value of 0.21 and the maximum value of 0.77 of the interference amount are reference base values verified by experiments. In actual design, data accuracy can be reduced as needed, for example, the minimum value is set to be 0.2 and the maximum value is set to be 0.7.

In further design example, the ideal range of the interference amount can first be determined through experimental verification, and the design size can be determined through the determined minimum target value Amin of the interference amount and the maximum target value Amax of the interference amount.

Design Embodiment 3

In a further embodiment, based on the relationships explained by formulas (1), (2), (5) and (6), the following constraint relationships can be obtained:

$$\sqrt{(w + a)^2 + [(1 + x\%) * t]^2} - \text{Amax} \leq (d - b) \leq (d + b) \leq$$
$$\sqrt{(w - a)^2 + [(1 - x\%) * t]^2} - Amin \qquad （9）$$

Therefore, formula (9) can be used as design constraints for the pinboard structure of PCB assembly.

If the processing accuracy of $t$, $d$ and $w$ is not to be considered, the constraints are simplified to be:

$$\sqrt{w^2 + t^2} - \text{Amax} \leq d \leq \sqrt{w^2 + t^2} - \text{Amin} \qquad （10）$$

Therefore, formula (10) can be used as constraints that the actually fabricated PCB assembly should satisfy, or as constraints for the design stage of the PCB assembly that is to be fabricated with high accuracy (so the processing accuracy parameter can be set to be 0 to simplify the design).

In the document of the present application, it is mainly described to use two positioning pins 204 and two positioning jacks 104 for fixing two PCBs. However, this is not essential. Other numbers of positioning pin and positioning jack can be provided. In embodiments of the present invention, the number of positioning pin(s) and positioning jack(s) that are required can be determined according to the length and width of the PCB. Table 1 shows the recommended number of positioning pin(s) and positioning jack(s) under different sizes of the second PCB 200 according to the embodiment of the present invention.

| PCB length M ⟍ PCB width N | M ＜ 50 mm | 50 mm≦M ＜150 mm | 150 mm≦M＜200 mm |
|---|---|---|---|
| N ＜ 50 mm | 1 pcs | 2 pcs | 3 pcs |
| 50 mm≦N＜150 mm | 2 pcs | 2 pcs | 3 pcs |

Table 1

Therefore, according to the commonly used PCB size, 1 to 3 positioning pins and positioning jacks can be designed respectively. In a preferred embodiment, in order to make the connection of the two PCBs more stable and firm, in an instance of designing two or more positioning pins and positioning jacks, the distance between respective positioning pins (and correspondingly, the distance between respective positioning jacks) can be designed to be as far as possible according to the actual PCB conditions.

Using the PCB connection structure designed by the present application, the positioning pin 204 of the second PCB 200 can be mechanically and automatically plugged into the positioning jack 104 of the first PCB 100 without manual insertion operation. In addition, due to the above-defined size design between the positioning pin 204 and the positioning jack 104, the first PCB 100 and the second PCB 200 can be firmly fixed together without the need for additional supports or fixtures to secure the two. Therefore, the PCB connection structure designed by the present application can realize fully automated PCB connection, greatly improving work efficiency and accuracy.

In the drawings and detailed embodiments of the present invention, it is mainly to describe the connection of two PCBs. However, the design structure and connection method of the present invention can also be used to connect more than two PCBs. In addition, the drawings of the present application show that positioning pins and positioning jacks are respectively provided at both ends of the PCBs. However, it is not intended to limit the technology of the present invention. The positioning pins and positioning jacks can be arranged in other places on the PCBs according to the required number of positioning pins and positioning jacks and the actual PCB connection requirement.

In the Specification and Claims of the present application, the expression "substantially rectangular cross-section" is used. It shall be appreciated that this generally rectangular cross-section is defined by the thickness of PCB 200 and the width of the positioning pins. In practical applications, the cross-section of the positioning pin 204 may not be an absolute rectangle. For example, one or more of its corners 206 may be chamfered to eliminate sharp edges. In this case, as long as the corners 206 are still outside the circumference of the positioning jack, interference can still be achieved. This situation shall still be considered to fall within the protection scope of the present application. Therefore, the present application seeks protection for "one or more positioning pins have a substantially rectangular cross-section", which covers the case where the four corners of the rectangle are not strictly angled.

The basic concept of the invention has been described above. It is apparent to those skilled in the art that the above disclosure is only example and does not constitute a limitation of the present application. Although not explicitly stated herein, those skilled in the art may make various modifications, improvements, and corrections to the present application. Such modifications, improvements and corrections are suggested in the present application, so such modifications, improvements and corrections still belong to the spirit and scope of the embodiments of the present application.

**Claims**

1.  A manufacturing method of a printed circuit board assembly, **characterized in that**, the method comprising:

    manufacturing a first printed circuit board comprising one or more positioning jacks;
    manufacturing a second printed circuit board comprising one or more positioning pins extending from a first edge of the second printed circuit board, the positioning pin having a substantially rectangular cross-sectional shape in a plane perpendicular to an extension direction of the positioning pin;
    wherein the one or more positioning pins of the second printed circuit board are configured to be respectively plugged into the one or more positioning jacks of the first printed circuit board, and a diagonal length $c$ of the cross-section of the positioning pin is larger than a diameter $d$ of the positioning jack, producing an interference fit between the positioning jack and the positioning pin,
    wherein, adopting the following definitions: a design size of the cross-sectional width of the positioning pin is $w$ and a processing tolerance thereof is $\pm a$, a design thickness of the second printed circuit board is $t$ and a processing tolerance thereof is $\pm x\%$, and Amin and Amax are the minimum target value and the maximum target value of an interference amount, and an actual size range of the diameter $d$ of the positioning jack are to be determined according to the following formulas:

    $$\sqrt{(w-a)^2 + [(1-x\%)*t]^2} - d \geq \mathrm{Amin}$$

    $$\sqrt{(w+a)^2 + [(1+x\%)*t]^2} - d \leq Amax$$

    further determining, based on the actual size range of the diameter $d$ of the positioning jack and a processing tolerance $\pm b$ of the positioning jack, a design size range of the diameter $d$,
    wherein the positioning jack and the positioning pin are to be manufactured according to design sizes of parameters $w$, $t$ and $d$.

2.  A manufacturing method of a printed circuit board assembly, **characterized in that**, the method comprising:

    manufacturing a first printed circuit board comprising one or more positioning jacks;
    manufacturing a second printed circuit board comprising one or more positioning pins extending from a first edge of the second printed circuit board, the positioning pin having a substantially rectangular cross-sectional shape in a plane perpendicular to an extension direction of the positioning pin;
    wherein the one or more positioning pins of the second printed circuit board are configured to be respectively plugged into the one or more positioning jacks of the first printed circuit board, and a diagonal length $c$ of the cross-section of the positioning pin is larger than a diameter $d$ of the positioning jack, producing an interference fit between the positioning jack and the positioning pin,
    wherein, adopting the following definitions: a design size of the diameter of the positioning jack is $d$ and a processing tolerance thereof is $\pm b$, a design thickness of the second printed circuit board is $t$ and a processing tolerance thereof is $\pm x\%$, and Amin and Amax are the minimum target value and the maximum target value of an interference amount, and an actual size range of the cross-sectional width w of the positioning pin are to be determined according to the following formulas:

    $$\sqrt{(w^2 + [(1-x\%)*t]^2} - (d+b) \geq Amin;$$

    $$\sqrt{(w^2 + [(1+x\%)*t]^2} - (d-b) \leq Amax$$

    further determining, based on the actual size range of the cross-sectional width w of the positioning pin and a processing tolerance $\pm a$ of the positioning pin, a design size range of the cross-sectional width $w$,
    wherein the positioning jack and the positioning pin are to be manufactured according to design sizes of parameters $w$, $t$ and $d$.

3.  A manufacturing method of a printed circuit board assembly, **characterized in that**, the method comprising:

manufacturing a first printed circuit board comprising one or more positioning jacks;

manufacturing a second printed circuit board comprising one or more positioning pins extending from a first edge of the second printed circuit board, the positioning pin having a substantially rectangular cross-sectional shape in a plane perpendicular to an extension direction of the positioning pin;

wherein the one or more positioning pins of the second printed circuit board are configured to be respectively plugged into the one or more positioning jacks of the first printed circuit board, and a diagonal length $c$ of the cross-section of the positioning pin is larger than a diameter $d$ of the positioning jack, producing an interference fit between the positioning jack and the positioning pin,

defining a design size the cross-sectional width of the positioning pin to be $w$ and a processing tolerance thereof to be $\pm a$, defining a design size of the diameter of the positioning jack is $d$ and a processing tolerance thereof to be $\pm b$, defining a design thickness of the second printed circuit board to be $t$ and a processing tolerance thereof to be $\pm x\%$, defining Amin and Amax to be the minimum target value and the maximum target value of an interference amount, and taking the following formulas as design constrains for parameters $w$, $d$ and $t$:

$$\sqrt{(w+a)^2 + [(1+x\%)*t]^2} - \text{Amax} \leq (d-b) \leq (d+b)$$
$$\leq \sqrt{(w-a)^2 + [(1-x\%)*t]^2} - Amin$$

wherein the positioning jack and the positioning pin are to be manufactured according to design sizes of the parameters $w$, $d$ and $t$ that satisfy the above constrains.

4. The manufacturing method of any of claims 1 to 3, wherein the minimum target value Amin and the maximum target value Amax are reference base values determined through a verification process.

5. The manufacturing method of claim 4, wherein the minimum target value Amin and the maximum target value Amax satisfy the following verification conditions:

when the interference amount is not lower than the minimum target value Amin, the stability of the first printed circuit board and the second printed circuit board that are mechanically connected meets requirement of welding process;

when the interference amount does not exceed the maximum target value Amax, there is no defect of circuit board on the first printed circuit board caused by excessive interference.

6. The manufacturing method of claim 5, wherein a range of the minimum target value Amin is 0.06~0.30 millimeters, and a range of the maximum target value Amax is 0.60-0.90 millimeters.

7. The manufacturing method of any of claims 1 to 3, wherein the positioning jack of the first printed circuit board and the positioning pin of the second printed circuit board do not include metal plating, and a material of the positioning pin is the same as a substrate material of the second printed circuit board.

8. The manufacturing method of any of claims 1 to 3, wherein the positioning pin includes an extension section with a constant width, and an end portion with a narrowing width, and the length $l$ of the extension section is greater than a thickness of the first printed circuit board.

9. The manufacturing method of claim 8, wherein an end of the positioning pin includes a chamfer.

10. The manufacturing method of any of claims 1 to 3, wherein the one or more positioning pins comprise 1 to 3 positioning pins, and the one or more positioning jacks comprise 1 to 3 positioning jacks.

11. The manufacturing method of any of claims 1 to 3, wherein the first printed circuit board further comprises one or more conductive jacks, and the second printed circuit board further comprises one or more conductive pins extending from the first edge of the second printed circuit board, and the one or more conductive pins and the one or more conductive jacks are applicable to establishing electrical connections by soldering.

12. The manufacturing method of any of claims 1 to 3, wherein a value of the processing tolerance $\pm x\%$ is 0.

13. The manufacturing method of claim 1 or claim 3, wherein a value of the processing tolerance $\pm a$ is 0.

14. The manufacturing method of claim 2 or claim 3, wherein a value of the processing tolerance $\pm b$ is 0.

15. A printed circuit board assembly, **characterized in that**, it comprising:

> a first printed circuit board comprising one or more positioning jacks;
> a second printed circuit board comprising one or more positioning pins extending from a first edge of the second printed circuit board, the positioning pin having a substantially rectangular cross-sectional shape in a plane perpendicular to an extension direction of the positioning pin;
> wherein the one or more positioning pins of the second printed circuit board are configured to be respectively plugged into the one or more positioning jacks of the first printed circuit board, a diagonal length c of the cross section of the positioning pin is greater than a diameter $d$ of the positioning jack, producing an interference fit between the positioning jack and the positioning pin.

16. The printed circuit board assembly of claim 15, wherein the positioning jack of the first printed circuit board and the positioning pin of the second printed circuit board do not include metal plating, and a material of the positioning pin is the same as a substrate material of the second printed circuit board.

17. The printed circuit board assembly of claim 15, wherein the positioning pin includes an extension section with a constant width and an end portion with a narrowing width, and the length $l$ of the extension section is greater than a thickness of the first printed circuit board.

18. The printed circuit board assembly of claim 17, wherein an end of the positioning pin includes a chamfer.

19. The printed circuit board assembly of any of claims 15-18, wherein the one or more positioning pins comprise 1 to 3 positioning pins, and the one or more positioning jacks comprise 1 to 3 positioning jacks.

20. The printed circuit board assembly of claim 19, wherein the number of the positioning pin is equal to the number of the positioning jack.

21. The printed circuit board assembly of claim 20, wherein the first printed circuit board comprises two positioning jacks, and the second printed circuit board comprises two positioning pins.

22. The printed circuit board assembly of claim 20, wherein the numbers of the positioning pin and the positioning jack are determined according to a size of the second printed circuit board:

> when a length M and a width N of the second printed circuit board satisfy the following sizes, the first printed circuit board comprises one positioning jack and the second printed circuit board comprises one positioning pin:

$$M < 50\text{mm}, N < 50\text{mm};$$

> when the length M and the width N of the second printed circuit board satisfy the following sizes, the first printed circuit board comprises 2 positioning jacks and the second printed circuit board comprises 2 positioning pins:

$$M < 50\text{mm}, 50\text{mm} \leq N < 150\text{mm};$$

$$50\text{mm} \leq M < 150\text{mm}, N < 50\text{mm};$$

> or

$$50\text{mm} \leq M < 150\text{mm}, 50\text{mm} \leq N < 150\text{mm};$$

> when the length M and the width N of the second printed circuit board satisfy the following sizes, the first printed circuit board comprises 3 positioning jacks and the second printed circuit board comprises 3 positioning pins:

$$150mm \leq M < 200mm, \ N < 50mm;$$

or

$$150mm \leq M < 200mm, \ 50mm \leq N < 150mm.$$

23. The printed circuit board assembly of any of claims 15 to 18, wherein the first printed circuit board further comprises one or more conductive jacks, and the second printed circuit board further comprises one or more conductive pins extending from the first edge of the second printed circuit board, and the one or more conductive pins and the one or more conductive jacks establish electrical connections by soldering.

24. The printed circuit board assembly of any of claims 15 to 18, wherein the cross-sectional width $w$ of the positioning pin is smaller than the diameter $d$ of the positioning jack.

25. The printed circuit board assembly of any of claims 15 to 18, wherein the first printed circuit board and the second printed circuit board are vertically connected.

26. The printed circuit board assembly of any of claims 15 to 18, wherein when the number of the positioning jack and the number of the positioning pin are greater than or equal to 2 respectively, sizes of at least two positioning jacks are different from each other, and accordingly, sizes of at least two positioning pins are different from each other.

27. The printed circuit board assembly of claim 15, wherein when the cross-sectional width of the positioning pin is defined as $w$, and the design thickness of the second printed circuit board is defined as $t$, then the $t$, $d$ and $w$ of the printed circuit board assembly satisfy the following constraints:

$$\sqrt{w^2 + t^2} - \text{Amax} \leq d \leq \sqrt{w^2 + t^2} - \text{Amin}$$

wherein Amax is a maximum of an interference amount $c\text{-}d$ obtained by subtracting the diameter $d$ of the positioning jack from the diagonal length $c$ of the cross-section of the positioning pin, and Amin is a minimum of the interference amount $c\text{-}d$.

20

202-1

202-N

102-1

102-N

10

Fig. 1

Fig. 2

Fig. 3

Fig. 4

Fig. 5

<div align="center">

**INTERNATIONAL SEARCH REPORT**

</div>

| | International application No. |
|---|---|
| | **PCT/CN2022/111141** |

---

**A. CLASSIFICATION OF SUBJECT MATTER**

H05K 3/36(2006.01)i; H05K 1/14(2006.01)i; H01R 12/71(2011.01)i

According to International Patent Classification (IPC) or to both national classification and IPC

**B. FIELDS SEARCHED**

Minimum documentation searched (classification system followed by classification symbols)

H05K; H01R

Documentation searched other than minimum documentation to the extent that such documents are included in the fields searched

Electronic data base consulted during the international search (name of data base and, where practicable, search terms used)

CNABS; CNTXT; CNKI; VEN; USTXT; EPTXT; WOTXT: 对角线, 孔, 过盈, 直径, 插销, 尺寸, diagonal, hole, via, interference, diameter, plug, dimension

**C. DOCUMENTS CONSIDERED TO BE RELEVANT**

| Category* | Citation of document, with indication, where appropriate, of the relevant passages | Relevant to claim No. |
|---|---|---|
| PX | CN 113473745 A (PHOENIX ASIAN-PACIFIC ELECTRIC (NANJING) CO., LTD. et al.) 01 October 2021 (2021-10-01) description, paragraphs [0004]-[0089], and figures 1-5 | 1-27 |
| PX | CN 215816477 U (PHOENIX ASIAN-PACIFIC ELECTRIC (NANJING) CO., LTD. et al.) 11 February 2022 (2022-02-11) description, paragraphs [0004]-[0061], and figures 1-5 | 1-27 |
| Y | CN 106028646 A (GUANGDONG OPPO MOBILE TELECOMMUNICATIONS CO., LTD.) 12 October 2016 (2016-10-12) description, paragraphs [0003]-[0051], and figures 1-3 | 15-26 |
| A | CN 106028646 A (GUANGDONG OPPO MOBILE TELECOMMUNICATIONS CO., LTD.) 12 October 2016 (2016-10-12) description, paragraphs [0003]-[0051], and figures 1-3 | 1-14, 27 |
| Y | JP H10335775 A (FUJI ELECTRIC CO., LTD.) 18 December 1998 (1998-12-18) description, paragraphs [0004]-[0011], and figures 1-3 | 15-26 |
| A | JP H10335775 A (FUJI ELECTRIC CO., LTD.) 18 December 1998 (1998-12-18) description, paragraphs [0004]-[0011], and figures 1-3 | 1-14, 27 |

☑ Further documents are listed in the continuation of Box C. ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **10 October 2022** | **18 October 2022** |

| Name and mailing address of the ISA/CN | Authorized officer |
|---|---|
| **China National Intellectual Property Administration (ISA/CN)** <br> **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**

| International application No. |
| :--- |
| **PCT/CN2022/111141** |

**C.     DOCUMENTS CONSIDERED TO BE RELEVANT**

| Category* | Citation of document, with indication, where appropriate, of the relevant passages | Relevant to claim No. |
| :---: | :--- | :---: |
| Y | US 2019006777 A1 (LUTRON ELECTRONICS, INC.) 03 January 2019 (2019-01-03) description, paragraphs [0013]-[0034], and figures 1A-6 | 15-26 |
| A | US 2019006777 A1 (LUTRON ELECTRONICS, INC.) 03 January 2019 (2019-01-03) description, paragraphs [0013]-[0034], and figures 1A-6 | 1-14, 27 |
| Y | CN 207354705 U (SHANGHAI KRAH SUOFU ELECTRONICS CO., LTD.) 11 May 2018 (2018-05-11) description, paragraphs [0003]-[0028], and figures 1-6 | 15-26 |
| A | CN 207354705 U (SHANGHAI KRAH SUOFU ELECTRONICS CO., LTD.) 11 May 2018 (2018-05-11) description, paragraphs [0003]-[0028], and figures 1-6 | 1-14, 27 |

Form PCT/ISA/210 (second sheet) (January 2015)

**INTERNATIONAL SEARCH REPORT**
Information on patent family members

International application No.

**PCT/CN2022/111141**

| Patent document cited in search report | | | Publication date (day/month/year) | Patent family member(s) | | | Publication date (day/month/year) |
|---|---|---|---|---|---|---|---|
| CN | 113473745 | A | 01 October 2021 | CN | 215816477 | U | 11 February 2022 |
| CN | 215816477 | U | 11 February 2022 | CN | 113473745 | A | 01 October 2021 |
| CN | 106028646 | A | 12 October 2016 | CN | 106028646 | B | 20 March 2020 |
| JP | H10335775 | A | 18 December 1998 | None | | | |
| US | 2019006777 | A1 | 03 January 2019 | WO | 2019006344 | A1 | 03 January 2019 |
| CN | 207354705 | U | 11 May 2018 | None | | | |

Form PCT/ISA/210 (patent family annex) (January 2015)